# EUROPÄISCHE PATENTSCHRIFT

(11) **EP 2 294 632 B1**
(45) Veröffentlichungstag und Bekanntmachung des Hinweises auf die Patenterteilung: **02.12.2020**
(21) Anmeldenummer: 09772002.3
(22) Anmeldetag: 25.06.2009
(51) Int. Cl.: H01L 33/58, H01L 31/054, H01L 33/38, H01L 31/0224

(54) **OPTOELEKTRONISCHE VORRICHTUNG ZUR REDUZIERUNG VON ABSCHATTUNGSEFFEKTEN DER ELEKTRODEN DURCH KONZENTRATOREN**
OPTOELECTRONIC DEVICE FOR REDUCING THE EFFECTS OF CONCENTRATORS SHIELDING OFF THE ELECTRODES
DISPOSITIF OPTOELECTRONIQUE PERMETTANT DE REDUIRE DES EFFETS D'OBSCURCISSEMENT DES ELECTRODES PAR LE BIAIS DE CONCENTRATEURS

(30) Priorität: 30.06.2008 DE 102008030819
(43) Veröffentlichungstag der Anmeldung: 16.03.2011
(73) Patentinhaber: OSRAM Opto Semiconductors GmbH, 93055 Regensburg (DE)
(72) Erfinder: BRICK, Peter, 93051 Regensburg (DE); MUSCHAWECK, Julius, 82131 Gauting (DE); FRANK, Joachim, 96450 Coburg (DE)
(74) Vertreter: Epping - Hermann - Fischer
(86) Internationale Anmeldenummer: PCT/DE2009/000882
(87) Internationale Veröffentlichungsnummer: WO 2010/000232

(56) Entgegenhaltungen:
- EP-A2- 0 255 900
- EP-A2- 0 255 900
- EP-A2- 1 427 025
- WO-A2-2004/097946
- WO-A2-2004/097946
- DE-A1-102005 018 336
- JP-B2- H0 671 093
- US-A- 4 638 110
- US-A- 4 964 713
- US-A- 4 964 713
- US-A- 5 123 968
- US-A- 5 344 497
- US-A- 5 959 787
- US-A- 6 057 505
- US-A- 6 091 017
- US-A1- 2005 081 908
- US-A1- 2006 185 713
- US-A1- 2007 012 934
- US-A1- 2007 012 934

## Beschreibung

Es wird eine optoelektronische Vorrichtung angegeben, die insbesondere für Detektorsysteme, energieerzeugende Systeme wie etwa Solarzellen oder Projektoren, beispielsweise Beamer, geeignet ist.

Diese Patentanmeldung beansprucht die Priorität der deutschen Patentanmeldung 10 2008 030 819.6, deren Offenbarungsgehalt hiermit durch Rückbezug aufgenommen wird.

In der Druckschrift DE 10 2005 033 005 A1 ist ein optoelektronischer Chip mit einer in mehrere strahlungsemittierende Bereiche unterteilten aktiven Zone und mehreren konvex gewölbten Teilbereichen beschrieben, die eine größere laterale Ausdehnung aufweisen als die strahlungsemittierenden Bereiche. Durch dieses Verhältnis zwischen den strahlungsemittierenden Bereichen und den konvex gewölbten Teilbereichen soll erreicht werden, dass die von den Bereichen emittierte Strahlung unter einem Winkel auf die Teilbereiche auftrifft, der kleiner ist als der Grenzwinkel der Totalreflexion, so dass die Strahlungsauskoppeleffizienz gesteigert werden kann.

Weiterhin sind in den Druckschriften US 5,123,968, US 2005/081908 und US 2006/185713 Systeme beschrieben, die Solarenergie erzeugen.

Eine zu lösende Aufgabe besteht darin, eine verlustarme optoelektronische Vorrichtung anzugeben.

Gemäß einer bevorzugten Ausführungsform umfasst die optoelektronische Vorrichtung eine optische Einrichtung mit einer optischen Struktur, die mehrere optische Elemente aufweist, sowie einen Strahlung emittierenden oder Strahlung empfangenden Halbleiterchip mit einer Kontaktstruktur, die mehrere Kontaktelemente zur elektrischen Kontaktierung des Halbleiterchips aufweist und von der optischen Struktur vertikal beabstandet ist, wobei die Kontaktelemente bei einer Projektion der Kontaktstruktur in die Ebene der optischen Struktur in Zwischenräumen zwischen den optischen Elementen angeordnet sind.

Durch die vertikale Beabstandung kann die gewünschte optische Wirkung erzielt werden, nämlich eine Bündelung der Strahlung in voneinander durch die Kontaktstruktur getrennten Bereichen einer Strahlungseintrittsfläche des Strahlung empfangenden Halbleiterchips oder eine Parallelrichtung der von diesen Bereichen ausgesandten Strahlung durch die optische Struktur.

Gemäß einer vorteilhaften Weiterbildung ist die Kontaktstruktur auf einer der optischen Einrichtung zugewandten Strahlungsdurchtrittsfläche des Halbleiterchips aufgebracht. Für den Strahlung emittierenden Halbleiterchip gilt, dass die Strahlungsdurchtrittsfläche der Strahlungsaustrittsfläche entspricht, während die Strahlungsdurchtrittsfläche im Falle des Strahlung empfangenden Halbleiterchips die Strahlungseintrittsfläche darstellt.

Vorzugsweise bedeckt die Kontaktstruktur nur Teilbereiche der Strahlungsdurchtrittsfläche des Halbleiterchips, das heißt durch die Kontaktstruktur ist keine ganzflächige Bedeckung der Strahlungsdurchtrittsfläche gegeben. Somit sind Strahlungsverluste, die durch Absorption von Strahlung an der Kontaktstruktur verursacht werden, bei der vorliegend durchbrochenen Kontaktstruktur verringert.

Weiterhin ist die optische Struktur vorzugsweise auf einer der Kontaktstruktur zugewandten Strahlungsdurchtrittsfläche der optischen Einrichtung angeordnet. Für den Strahlung emittierenden Halbleiterchip gilt, dass die Strahlungsdurchtrittsfläche der optischen Einrichtung der Strahlungseintrittsfläche der optischen Einrichtung entspricht, während die Strahlungsdurchtrittsfläche im Falle des Strahlung empfangenden Halbleiterchips die Strahlungsaustrittsfläche der optischen Einrichtung darstellt.

Durch die optische Struktur kann im Falle des Strahlung empfangenden Halbleiterchips die transmittierte Strahlung in lateral voneinander getrennten Bereichen der Strahlungsdurchtrittsfläche gesammelt werden, wobei die Bestrahlungsstärke zwischen den Bereichen relativ stark absinkt. In diesen Zwischenbereichen geringerer Bestrahlungsstärke ist mit Vorteil die Kontaktstruktur angeordnet. Die Zwischenbereiche geringer Bestrahlungsstärke korrespondieren insbesondere zu den Zwischenräumen zwischen den optischen Elementen der optischen Struktur. Die Kontaktstruktur befindet sich außerhalb des Hauptstrahlengangs, so dass eine Abschattung durch die Kontaktstruktur im Wesentlichen verhindert wird. Dadurch lassen sich Strahlungsverluste stark reduzieren.

Vorteilhafterweise ermöglicht die optische Struktur im Falle des Strahlung emittierenden Halbleiterchips ein "Ausblenden" der Kontaktstruktur, so dass eine der optischen Einrichtung aus Sicht des Halbleiterchips nachgeordnete Fläche homogen leuchtet und nicht durch die Kontaktstruktur unterbrochen ist. Durch die Kontaktstruktur werden voneinander getrennte Leuchtbereiche erzeugt, die durch die optische Einrichtung beziehungsweise die optische Struktur zu einer gleichmäßig leuchtenden Fläche vereinigt werden.

Die Kontaktstruktur kann in Form einer strukturierten Beschichtung, die ein elektrisch leitendes Material, insbesondere ein Metall, enthält, auf die Strahlungsdurchtrittsfläche des Halbleiterchips aufgebracht sein.

Die optische Struktur kann aus einem strahlungsdurchlässigen Material gebildet sein. Ein geeignetes Material ist beispielsweise Glas. Dies weist gegenüber kurzwelliger Strahlung, insbesondere ultravioletter Strahlung, eine relativ gute Alterungsbeständigkeit auf.

Die optische Struktur weist mit Vorteil eine periodische Struktur auf, das heißt die optischen Elemente der optischen Struktur sind regelmäßig angeordnet.

Gemäß einer vorteilhaften Ausgestaltung bilden die optischen Elemente ein Linsenarray oder ein optisches Gitter. Beispielsweise kann das Linsenarray eine Mehrzahl regelmäßig angeordneter Linsen umfassen, die auf der dem Halbleiterchip zugewandten Seite eine konvex gewölbte Oberfläche aufweisen. Insbesondere kann sich eine Strahlung emittierende oder Strahlung empfangende Zone des Halbleiterchips in einer Ebene oder nahe einer Ebene befinden, die durch die Brennpunkte der Linsen aufgespannt wird. Somit wird durch die optische Struktur die auf den Halbleiterchip auftreffende Strahlung in der Strahlung empfangenden Zone fokussiert, während die von dem Halbleiterchip emittierte Strahlung durch die optische Struktur parallel gerichtet wird.

Entsprechend der optischen Struktur kann auch die Kontaktstruktur eine periodische Struktur aufweisen. Insbesondere stimmt die Periodizität der Kontaktstruktur mit der Periodizität der optischen Struktur überein, das heißt die Kontaktelemente sind mit derselben Regelmäßigkeit angeordnet wie die optischen Elemente.

Gemäß einer vorteilhaften Ausgestaltung ist die Kontaktstruktur aus netzartig angeordneten Kontaktelementen gebildet. Die Kontaktelemente können insbesondere Kontaktstege sein. Vorzugsweise weist hierbei die optische Struktur am Ort der Zwischenräume der Kontaktstruktur die optischen Elemente, beispielsweise Linsen, auf.

Gemäß der Erfindung umfasst die optische Einrichtung einen Konzentrator. Auf einer dem Halbleiterchip zugewandten Seite weist der Konzentrator eine erste Apertur auf, die insbesondere kleiner ist als eine auf einer dem Halbleiterchip abgewandten Seite angeordnete zweite Apertur des Konzentrators. Mittels des Konzentrators kann die Chipgröße bei ausreichender Bestrahlungsstärke relativ klein gehalten werden, was die Materialkosten senkt. Die zweite Apertur kann mit Vorteil etwa 10 bis 1000 Mal größer sein als die erste Apertur oder die der ersten Apertur vorzugsweise entsprechende Strahlungsdurchtrittsfläche des Halbleiterchips. Die Länge des Konzentrators ist festgelegt durch die zweite beziehungsweise erste Apertur und den Öffnungswinkel des Konzentrators.

Eine vorteilhafte Ausgestaltung der optischen Einrichtung sieht einen parabolischen Konzentrator vor. Der parabolische Konzentrator gleicht im Querschnitt einer stückweisen Parabel und hat die Eigenschaft, innerhalb eines bestimmten Winkels zur Symmetrieachse einfallende Strahlung in einer begrenzten Fläche zu fokussieren beziehungsweise von dieser Fläche ausgehende Strahlung in einen begrenzten Winkelbereich abzustrahlen. Vorzugsweise ist die optische Struktur im Bereich der ersten Apertur nahe des Brennpunkts angeordnet.

Gemäß der Erfindung ist der Konzentrator ein Vollkörper, der an einer dem Halbleiterchip zugewandten Oberfläche die optische Struktur aufweist. Die Kombination aus Konzentrator und optischer Struktur ist einstückig ausgebildet, wobei beide Elemente vorzugsweise das gleiche Material enthalten, beispielsweise Glas. Die Strahlung wird im Konzentrator vorrangig durch Totalreflexionen an der Außenwand geführt.

Alternativ zur Erfindung ist es auch möglich, den Konzentrator als Hohlkörper mit einer reflektierenden Innenfläche vorzusehen, dem auf einer dem Halbleiterchip zugewandten Seite die optische Struktur nachgeordnet ist. Hierbei sind die beiden Elemente vorzugsweise zwei separate Elemente, die nicht aus dem gleichen Material hergestellt sind. Der Hohlkörper kann beispielsweise aus einem Kunststoffmaterial hergestellt sein und auf der Innenfläche eine reflektierende Beschichtung, die insbesondere ein Metall enthält, aufweisen. Die optische Struktur kann aus Glas gebildet sein.

Gemäß einer vorteilhaften Weiterbildung weist der Halbleiterchip eine Strahlung emittierende oder Strahlung empfangende Zone auf, die in den von der Kontaktstruktur unbedeckten Bereichen funktionsfähig ist. Vorzugsweise ist die Strahlung emittierende oder Strahlung empfangende Zone auch in den von der Kontaktstruktur bedeckten Bereichen funktionsfähig, das heißt die Größe der funktionsfähigen Bereiche entspricht in der Summe vorzugsweise der gesamten Fläche der Strahlung emittierenden oder Strahlung empfangenden Zone.
Der Zwischenraum, durch welchen die optische Struktur und der Halbleiterchip vertikal voneinander beabstandet sind, weist mit Vorteil einen von der optischen Struktur verschiedenen Brechungsindex auf. Beispielsweise kann sich in dem Zwischenraum Luft (Brechungsindex n = 1) oder Silikon (Brechungsindex beispielsweise n= 1.4) befinden. Die optische Struktur kann mit Glas (Brechungsindex beispielsweise n = 1.5) gebildet sein.

Gemäß einer bevorzugten Ausgestaltung ist der Strahlung emittierende Halbleiterchip eine Leuchtdiode. Gemäß einer weiteren Ausgestaltung ist der Strahlung empfangende Halbleiterchip ein Strahlungsdetektor oder eine Solarzelle. Der Halbleiterchip umfasst eine Strahlung emittierende oder Strahlung empfangende Zone mit einem Strahlung erzeugenden oder empfangenden pn-Übergang. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden Schicht die eigentliche Strahlung erzeugende oder empfangende Schicht ausgebildet. Insbesondere kann im Falle eines Strahlung emittierenden Halbleiterchips die eigentliche Strahlung erzeugende Schicht in Form einer dotierten oder undotierten Quantenschicht ausgebildet sein. Die Quantenschicht kann als Einfachquantentopfstruktur (SQW, Single Quantum Well) oder Mehrfachquantentopfstruktur (MQW, Multiple Quantum Well) oder auch als Quantendraht oder Quantenpunktstruktur ausgeformt sein.

Der als Strahlungsdetektor ausgebildete Halbleiterchip kann insbesondere mehr als eine Strahlung empfangende Zone aufweisen. Die Strahlung empfangenden Zonen können übereinander angeordnet sein und Strahlung unterschiedlicher Wellenlänge absorbieren.

Für den Halbleiterchip geeignete Materialien sind unter anderem III-V-Halbleiter, insbesondere Arsenid-, Phosphid-oder Nitrid- Verbindungshalbleiter mit der Materialzusammensetzung AlₙGaₘIn₁₋ₙ₋ₘAs, AlₙGaₘIn₁₋ₙ₋ₘP oder AlₙGaₘIn₁₋ₙ₋ₘN, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Darüber hinaus kann der Halbleiterchip einen Elementhalbleiter wie Silizium oder einen II-VI-Verbindungshalbleiter, was im Falle der Solarzelle besonders geeignet ist, enthalten. Außerdem kann Germanium im Falle des Strahlungsdetektors für eine erste Strahlung empfangende Zone verwendet werden, während eine zweite empfangende Zone aus einem III-V-Halbleiter gebildet sein kann.

Es sei darauf hingewiesen, dass vorliegend mit "vertikal" eine Richtung gemeint ist, in welcher die optische Struktur dem Halbleiterchip nachgeordnet ist. Unter "lateral" ist eine Richtung senkrecht zur vertikalen Richtung zu verstehen.

Im folgenden wird die oben beschriebene optoelektronische Vorrichtung anhand der Figuren 1 bis 7 näher erläutert.

Es zeigen:
- Figur 1: eine schematische Querschnittsansicht einer optoelektronischen Vorrichtung zur Veranschaulichung der Wirkung der optischen Einrichtung,
- Figur 2: eine schematische Querschnittsansicht der optoelektronischen Vorrichtung mit Halbleiterchip, optischer Struktur und Konzentrator,
- Figur 3: eine schematische Querschnittsansicht des Halbleiterchips und der optischen Struktur zur Veranschaulichung des Strahlengangs zwischen optischer Struktur und Halbleiterchip,
- Figur 4: ein Punktediagramm einer Intensitätsverteilung auf der Strahlungsdurchtrittsfläche des Halbleiterchips,
- Figur 5: ein Schaubild darstellend die eingeschlossene Energie in einem beleuchteten Bereich des Halbleiterchips,
- Figur 6: eine schematische Draufsicht einer Kontaktstruktur,
- Figur 7: eine schematische Querschnittsansicht eines Strahlung emittierenden oder Strahlung empfangenden Halbleiterchips.

Gleiche oder gleichwirkende Elemente sind in den Figuren mit den gleichen Bezugszeichen versehen.

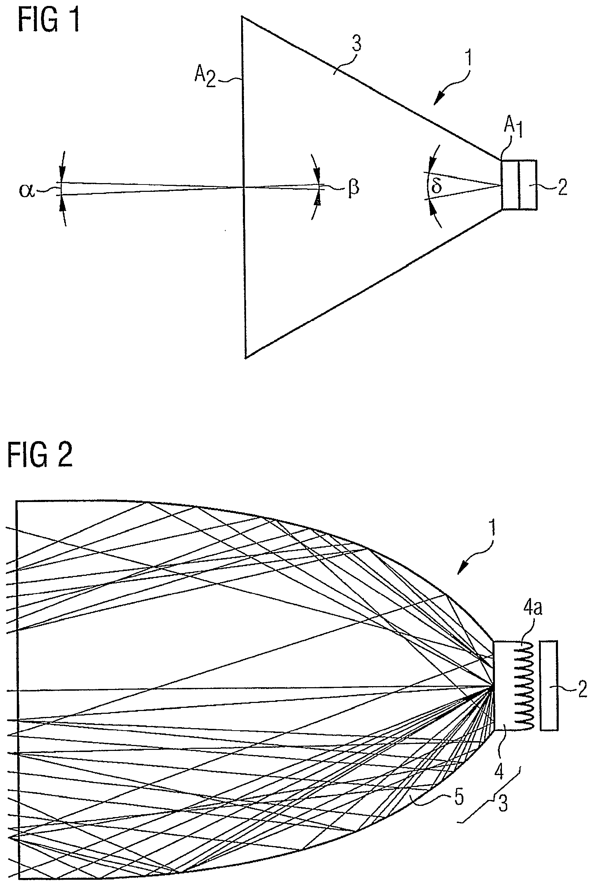

In Figur 1 ist eine optoelektronische Vorrichtung 1 dargestellt, die einen Strahlung emittierenden oder Strahlung empfangenden Halbleiterchip 2 und eine optische Einrichtung 3 aufweist.

Wie aus Figur 1 ersichtlich ist, weist die optische Einrichtung 3 auf einer dem Halbleiterchip 2 zugewandten Seite eine erste Apertur A₁ auf, die kleiner ist als eine auf der dem Halbleiterchip 2 abgewandten Seite angeordnete zweite Apertur A₂. Die Chipgröße ist vorzugsweise an die Größe der ersten Apertur A₁ angepasst und weist insbesondere dieselben lateralen Abmessungen wie die erste Apertur A₁ auf.

Der Halbleiterchip 2 kann einen rechteckförmigen, insbesondere quadratischen, Grundriss aufweisen, wobei die Grundrissfläche Werte zwischen 0.0001 cm² (100µm x 100µm) und 10 cm² annehmen kann. Die untere Grenze wird bestimmt durch die Herstellbarkeit beziehungsweise Wirksamkeit der Kontaktstruktur. Die obere Grenze wird bestimmt durch die Realisierbarkeit der optischen Einrichtung.

Eine geeignete Größe für die zweite Apertur A₂ ist beispielsweise 100 cm². Mit Vorteil weist der Halbleiterchip 2 hierbei eine Grundrissfläche von 1 cm² auf.

Durch den Winkel α ist der Öffnungswinkel des Strahlungskegels bezeichnet, der durch die zweite Apertur A₂ aus der optischen Einrichtung 3 austritt oder durch die zweite Apertur A₂ in die optische Einrichtung 3 eintritt. Wird als Strahlungsquelle eine weit entfernte Strahlungsquelle wie die Sonne angenommen, so ist der Winkel α relativ klein und liegt bei etwa 1° (± 0.5°). In der optischen Einrichtung 3 verkleinert sich der Winkel α des Strahlungskegels zum Winkel β und liegt beispielsweise bei etwa 0.7° (± 0.35°). Aufgrund der Erhaltung des Etendue in der optischen Einrichtung 3 ist der an der ersten Apertur 1 auftretende Winkel δ größer als der an der zweiten Apertur A₂ auftretende Winkel β, da die erste Apertur 1 kleiner ist als die zweite Apertur A₂. Der Winkel δ beträgt in diesem Fall 7° (± 3.5°). Der Raumwinkelfaktor beträgt 100.

Ist der Halbleiterchip 2 ein Strahlungsempfänger, kann Sonnenlicht mit einer Bestrahlungsstärke von 1000 W/m² durch die zweite Apertur A₂, die wie bereits erwähnt eine Fläche von 100 cm² aufweisen kann, treten, so dass auf einer 1 cm² großen Strahlungsdurchtrittsfläche des Halbleiterchips 2 eine Strahlungsleistung von 10 W erzielt wird.

Ist der Halbleiterchip 2 eine Strahlungsquelle, so kann durch die optische Einrichtung 3 Strahlung mit vergleichsweise geringer Divergenz abgestrahlt werden. Die optoelektronische Vorrichtung 1 ist hierdurch für die Verwendung in Projektoren besonders geeignet.

Figur 2 zeigt eine mögliche Ausgestaltung der optischen Einrichtung 3. Diese kann einen parabolischen Konzentrator 5 aufweisen, der die einfallende Strahlung möglichst verlustarm durch den Konzentratorkörper führt.

Der Konzentrator 5 kann beispielsweise ein Vollkörper sein, an dessen Außenwand die Strahlung totalreflektiert wird und somit im Konzentrator 5 gehalten wird. Alternativ kann der Konzentrator 5 ein Hohlkörper mit einer verspiegelten Innenfläche sein.

Desweiteren umfasst die optische Einrichtung 3 auf einer dem Halbleiterchip 2 zugewandten Seite eine optische Struktur 4. Die optische Struktur 4 kann ein separates Element sein, das vorzugsweise mit dem Konzentrator 5 mechanisch verbunden ist. Alternativ kann die optische Struktur 4 einstückig mit dem Konzentrator 5 ausgebildet sein, das heißt optische Struktur 4 und Konzentrator 5 werden in einem Arbeitsschritt vorzugsweise aus dem gleichen Material hergestellt. Letztere Möglichkeit findet bevorzugt Anwendung, wenn der Konzentrator 5 ein Vollkörper ist.

Die optische Struktur 4 weist mit Vorteil eine periodische Struktur auf. Wie dargestellt, umfasst die optische Struktur 4 eine Mehrzahl regelmäßig angeordneter optischer Elemente 4a. Insbesondere sind die optischen Elemente 4a Linsen mit einer konvexen Oberfläche.

Vorzugsweise entspricht die optische Struktur 4 in ihrem Grundriss dem Grundriss des Halbleiterchips 2. Bei einer Grundrissfläche von 1 cm² kann die optische Struktur 4 beispielsweise pro mm² ein optisches Element 4a aufweisen, das heißt der Durchmesser eines einzelnen optischen Elements 4a beträgt etwa 1 mm.

Aufgrund der Strahlungsdurchlässigkeit von Glas kann dieses Material mit Vorteil für die optische Struktur 4 verwendet werden.

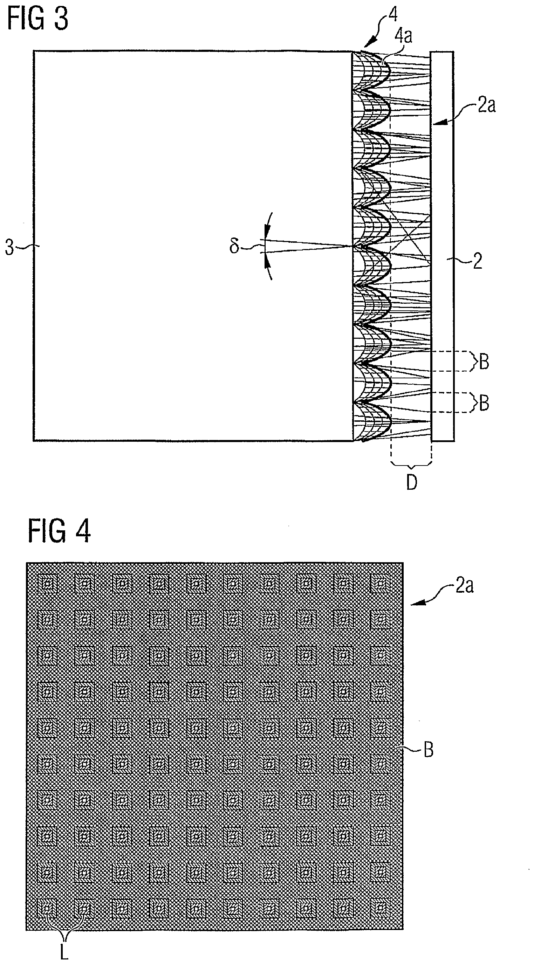

Figur 3 zeigt einen vergrößerten Ausschnitt einer wie in den Figuren 1 und 2 dargestellten optoelektronischen Vorrichtung.

Die optische Struktur 4 weist eine Mehrzahl von optischen Elementen 4a auf, welche insbesondere als Linsen ausgebildet sind. Dies wurde bereits im Zusammenhang mit Figur 2 näher erläutert.

Wie aus der Figur 3 ersichtlich ist, konvergieren die durch Linien dargestellten Lichtstrahlen eines durch die jeweiligen optischen Elemente 4a erzeugten Strahlenbündels beziehungsweise divergieren im Falle eines Strahlung emittierenden Halbleiterchips. Zwischen den auf den Halbleiterchip 2 auftreffenden Strahlenbündeln oder den von diesem ausgesandten Strahlenbündeln sind Bereiche B geringerer Intensität vorhanden. In diesen Bereichen B weist der Halbleiterchip 2 Kontaktelemente (nicht dargestellt) auf, die zusammen eine Kontaktstruktur bilden. Die Kontaktstruktur ist vorzugsweise auf einer Strahlungsdurchtrittsfläche 2a des Halbleiterchips 2 angeordnet.

Der Halbleiterchip 2 beziehungsweise die Strahlung empfangende oder emittierende Zone muss nicht unmittelbar in der Ebene angeordnet sein, die durch die Brennpunkte der optischen Elemente 4a aufgespannt wird. Der Halbleiterchip 2 kann nahe dieser Ebene, in einem etwas kleineren vertikalen Abstand D zur optischen Struktur 4 angeordnet sein. Der Abstand D zwischen der optischen Struktur 4 und dem Halbleiterchip 2 ist insbesondere so groß gewählt, dass die Kontaktstruktur groß genug ausgebildet werden kann, ohne dass die Gefahr einer Abschattung durch die Kontaktstruktur besteht. Weiterhin ist der Abstand so klein gewählt, dass die Bereiche B groß genug sind, um die Chipfläche optimal zu nutzen.

In Figur 4 ist eine simulierte Intensitätsverteilung dargestellt, wie sie auf der Strahlungsdurchtrittsfläche 2a eines Strahlung empfangenden Halbleiterchips 2 gemäß den Figuren 1 bis 3 auftreten kann.

Die Strahlungsdurchtrittsfläche 2a weist eine Größe von 1 cm x 1 cm auf. Die Strahlung wird in voneinander getrennten Bereichen L gesammelt, die in ihrer Anzahl der Zahl der optischen Elemente 4a (vgl. Figur 3) entsprechen. Es treten also 10 x 10 Bereiche L auf der Strahlungsdurchtrittsfläche 2a auf. Die durch die Strahlenbündel beleuchteten Bereiche L sind gleichmäßig auf der Strahlungsdurchtrittsfläche 2a verteilt und durch die Bereiche B geringerer Intensität voneinander getrennt.

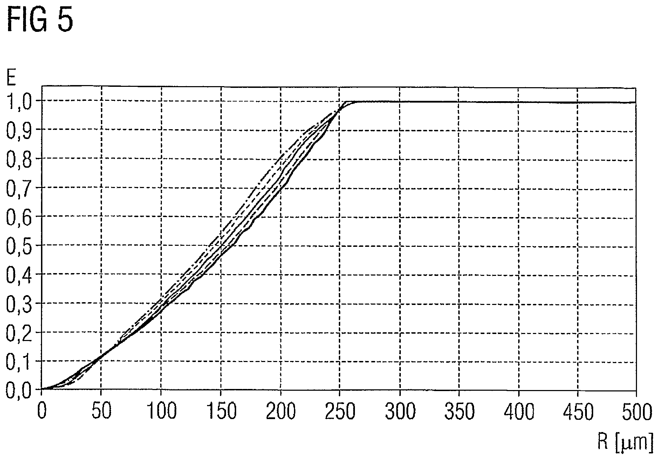

Aus Figur 5 geht die Ausdehnung der beleuchteten Bereiche L hervor. Die Ordinate gibt den Anteil E der eingeschlossenen Energie innerhalb eines Bereichs L mit dem Radius R an ausgehend von dessen Schwerpunkt. Die Abszisse gibt den Radius R an. Die verschiedenen Kurven stellen die Werte für verschiedene Strahlen dar, die unter verschiedenen Winkeln, insbesondere ±3.5°, auf den Bereich L auftreffen. Wie aus Figur 5 ersichtlich ist, sind innerhalb eines Bereichs L mit dem Radius R = 250 µm mehr als 95% (E = 1) der Energie eingeschlossen, wenn die Strahlung innerhalb eines Winkelbereichs von ±3.5° auftrifft. Der mittlere Durchmesser der Bereiche L kann also bei etwa 500 µm angenommen werden.

Der Abstand zwischen den Schwerpunkten der Bereiche L beträgt hier etwa 1 mm. Somit kann die Breite der Bereiche B zwischen den Bereichen L bis zu 500 µm betragen. Infolgedessen ist in den Bereichen B ausreichend Platz für die Kontaktelemente.

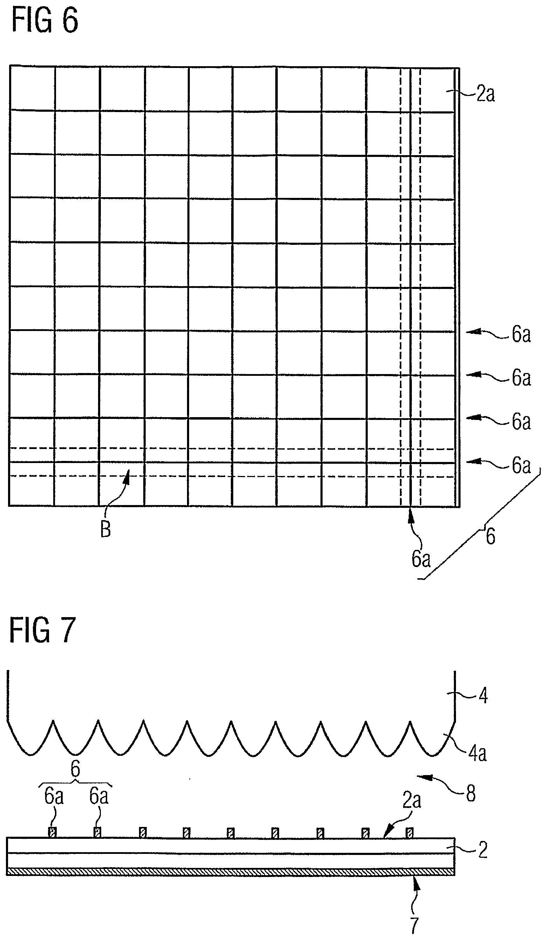

Figur 6 zeigt die in Figur 4 dargestellte Strahlungsdurchtrittsfläche 2a, die nunmehr in den Bereichen B geringer Intensität mit Kontaktelementen 6a, welche die Kontaktstruktur 6 bilden, versehen ist. Die Kontaktstruktur 6 weist eine periodische Struktur auf, wobei die Periodizität der Kontaktelemente 6a mit der Periodizität der beleuchteten Bereiche L übereinstimmt. Die beleuchteten Bereiche L können den in Figur 3 dargestellten optischen Elementen 4a der optischen Struktur 4 eineindeutig zugeordnet werden. Folglich stimmt die Periodizität der Kontaktstruktur 6 auch mit der Periodizität der optischen Struktur 4 überein.

Die Kontaktstruktur 6 ist aus netzartig angeordneten Kontaktelementen 6a in Form von Kontaktstegen gebildet. Diese enthalten vorzugsweise ein Metall oder eine Metallverbindung. Die Breite der Kontaktstege ist an die Breite der Bereiche B angepasst. Weisen diese eine Breite von etwa 500 µm auf, so können die Kontaktstege etwa 300 µm breit sein. Es sind jedoch je nach Anwendung auch kleinere Strukturen bis 10 µm denkbar.

Figur 7 zeigt einen vergrößerten Ausschnitt aus einer optoelektronischen Vorrichtung, wie sie beispielsweise in Figur 2 dargestellt ist. Die optoelektronische Vorrichtung umfasst den Halbleiterchip 2, der eine Leuchtdiode, ein Strahlungsdetektor oder eine Solarzelle sein kann, und die optische Struktur 4 mit den optischen Elementen 4a.

Auf der Strahlungsdurchtrittsfläche 2a des Halbleiterchips 2 ist die Kontaktstruktur 6 mit den Kontaktelementen 6a in Form von Kontaktstegen angeordnet. Die Kontaktstruktur 6 ist von der optischen Struktur 4 vertikal beabstandet. Insbesondere befindet sich ein Zwischenraum 8 zwischen der optischen Struktur 4 und dem Halbleiterchip 2. Der Zwischenraum 8 weist mit Vorteil einen von der optischen Struktur 4 verschiedenen Brechungsindex auf, der insbesondere kleiner ist. Beispielsweise kann der Zwischenraum 8 mit Luft oder Silikon gefüllt sein.

Auf der Rückseite weist der Halbleiterchip 2 einen Rückseitenkontakt 7 auf, der den Halbleiterchip 2 ganzflächig bedecken kann.

Bei einer Projektion der Kontaktstruktur 6 in die Ebene der optischen Struktur 4 sind die Kontaktelemente 6a in Zwischenräumen zwischen den optischen Elementen 4a angeordnet. Insbesondere werden die optischen Elemente 4a bei einer Projektion von den Kontaktelementen 6a rahmenartig umschlossen.

Die Anordnung der optischen Struktur 4 relativ zur Kontaktstruktur 6 bewirkt im Falle eines Strahlung empfangenden Halbleiterchips 2, dass durch die Kontaktstruktur 6 keine Abschattung durch die Kontaktstruktur 6 auftritt.

Im Falle eines Strahlung emittierenden Halbleiterchips 2 kann durch die beschriebene Anordnung mehr Strahlung in den Konzentrator (nicht dargestellt) beziehungsweise eine nachgeordnete Projektoroptik (nicht dargestellt) eingekoppelt werden oder die Projektoroptik kann für ein kleineres Etendue ausgelegt werden. Denn durch die optische Struktur 4 wird nur die Strahlung zwischen den Kontaktelementen 6a verarbeitet. Die leuchtende Fläche entspricht also nicht der Größe der Strahlungsdurchtrittsfläche 2a, sondern ist um die Größe der Kontaktelemente reduziert. Das Etendue (Produkt aus leuchtender Fläche und Raumwinkel) ist also kleiner. Mittels einer derartigen optoelektronischen Vorrichtung kann also ein etenduebegrenztes System mit erhöhter Leuchtdichte erzielt werden. Eine solche Vorrichtung ist insbesondere für Projektoren geeignet.

Die Erfindung ist nicht durch die Beschreibung anhand der Ausführungsbeispiele beschränkt sondern ausschließlich durch die folgenden Ansprüche.

## Patentansprüche

1. Optoelektronische Vorrichtung (1) umfassend
- eine optische Einrichtung (3) mit einer optischen Struktur (4), die mehrere optische Elemente (4a) aufweist, und mit einem Konzentrator (5),
- einen Strahlung emittierenden oder Strahlung empfangenden Halbleiterchip (2) mit einer Kontaktstruktur (6), die mehrere Kontaktelemente (6a) zur elektrischen Kontaktierung des Halbleiterchips (2) aufweist und von der optischen Struktur (4) vertikal beabstandet ist, wobei die Kontaktelemente (6a) bei einer Projektion der Kontaktstruktur (6) in die Ebene der optischen Struktur (4) in Zwischenräumen zwischen den optischen Elementen (4a) angeordnet sind, und wobei
- der Konzentrator (5) auf einer dem Halbleiterchip (2) zugewandten Seite eine kleinere Apertur aufweist als auf einer dem Halbleiterchip (2) abgewandten Seite,
- die optische Struktur (4) auf der dem Halbleiterchip (2) zugewandten Seite des Konzentrators (5) angeordnet ist,
- der Konzentrator (5) ein Vollkörper ist und dadurch gekennzeichtnet, dass
- der Konzentrator (5) und die optische Struktur (4) einstückig ausgebildet sind.

2. Optoelektronische Vorrichtung (1) nach Anspruch 1, wobei die Kontaktstruktur (6) auf einer der optischen Einrichtung (3) zugewandten Strahlungsdurchtrittsfläche (2a) des Halbleiterchips (2) aufgebracht ist.

3. Optoelektronische Vorrichtung (1) nach einem der vorhergehenden Ansprüche, wobei
die optische Struktur (4) eine periodische Struktur ist und
die optischen Elemente (4a) beispielsweise ein Linsenarray oder ein optisches Gitter bilden.

4. Optoelektronische Vorrichtung (1) nach einem der vorhergehenden Ansprüche, wobei
die optische Struktur (4) Glas enthält.

5. Optoelektronische Vorrichtung (1) nach Anspruch 3 oder 4, wobei die Kontaktstruktur (6) eine periodische Struktur ist, deren Periodizität mit der Periodizität der optischen Struktur (4) übereinstimmt.

6. Optoelektronische Vorrichtung (1) nach Anspruch 5, wobei die Kontaktstruktur (6) netzartig angeordnete Kontaktelemente (6a), insbesondere Kontaktstege, aufweist.

7. Optoelektronische Vorrichtung (1) nach einem der vorhergehenden Ansprüche, wobei
der Konzentrator (5) ein parabolischer Konzentrator ist.

8. Optoelektronische Vorrichtung (1) nach einem der vorhergehenden Ansprüche, wobei
der Halbleiterchip (2) eine Strahlung emittierende oder Strahlung empfangende Zone aufweist, die in den von der Kontaktstruktur (6) bedeckten Bereichen funktionsfähig ist.

9. Optoelektronische Vorrichtung (1) nach einem der vorhergehenden Ansprüche, wobei
ein Zwischenraum (8) zwischen der optischen Struktur (4) und dem Halbleiterchip (2) einen von der optischen Struktur (4) verschiedenen Brechungsindex aufweist.

10. Optoelektronische Vorrichtung (1) nach dem vorhergehenden Anspruch, wobei
sich in dem Zwischenraum (8) Luft oder Silikon befindet.

11. Optoelektronische Vorrichtung (1) nach einem der vorhergehenden Ansprüche, wobei
der Strahlung emittierende Halbleiterchip (2) eine Leuchtdiode ist.

12. Optoelektronische Vorrichtung (1) nach einem der Ansprüche 1 bis 10, wobei
der Strahlung empfangende Halbleiterchip (2) ein Strahlungsdetektor oder eine Solarzelle ist.

13. Optoelektronische Vorrichtung (1) nach einem der vorhergehenden Ansprüche, wobei
eine Fläche der kleineren Apertur des Konzentrators (5) gleich groß ist wie eine Grundrissfläche der optischen Struktur (4).

## Claims

1. An optoelectronic apparatus (1) comprising
- an optical device (3) having an optical structure (4) which comprises a plurality of optical elements (4a), and having a concentrator (5),
- a radiation-emitting or radiation-receiving semiconductor chip (2) with a contact structure (6) which comprises a plurality of contact elements (6a) for electrically contacting the semiconductor chip (2) and is spaced apart vertically from the optical structure (4), wherein the contact elements (6a) are arranged in interspaces between the optical elements (4a) upon a projection of the contact structure (6) into the plane of the optical structure (4), and wherein
- the concentrator (5) has a smaller aperture on a side facing the semiconductor chip (2) than on a side facing away from the semiconductor chip (2),
- the optical structure (4) is arranged on the side of the concentrator (5) facing the semiconductor chip (2),
- the concentrator (5) is a solid body and **characterized in that**
- the concentrator (5) and the optical structure (4) are embodied in one piece.

2. The optoelectronic apparatus (1) according to claim 1, wherein the contact structure (6) is applied on a radiation passage area (2a) of the semiconductor chip (2), the radiation passage area (2a) facing the optical device (3).

3. The optoelectronic apparatus (1) according to one of the preceding claims, wherein the optical structure (4) is a periodic structure and the optical elements (4a), for example, form a lens array or an optical grating.

4. The optoelectronic apparatus (1) according to one of the preceding claims, wherein the optical structure (4) contains glass.

5. The optoelectronic apparatus (1) according to claim 3 or 4, wherein the contact structure (6) is a periodic structure whose periodicity corresponds to the periodicity of the optical structure (4).

6. The optoelectronic apparatus (1) according to claim 5, wherein the contact structure (6) comprises contact elements (6a), in particular contact webs, arranged in a reticulated fashion.

7. The optoelectronic apparatus (1) according to one of the preceding claims, wherein the concentrator (5) is a parabolic concentrator.

8. The optoelectronic apparatus (1) according to one of the preceding claims, wherein the semiconductor chip (2) comprises a radiation-emitting or radiation-receiving zone which is functional in the regions covered by the contact structure (6) .

9. The optoelectronic apparatus (1) according to one of the preceding claims, wherein an interspace (8) between the optical structure (4) and the semiconductor chip (2) has a different refractive index than the optical structure (4).

10. The optoelectronic apparatus (1) according to the preceding claim, wherein air or silicone is situated in the interspace (8).

11. The optoelectronic apparatus (1) according to one of the preceding claims, wherein the radiation-emitting semiconductor chip (2) is a light-emitting diode.

12. The optoelectronic apparatus (1) according to one of claims 1 to 10, wherein the radiation-receiving semiconductor chip (2) is a radiation detector or a solar cell.

13. The optoelectronic apparatus (1) according to one of the preceding claims, wherein an area of the smaller aperture of the concentrator (5) is as big as a plan area of the optical structure (4).

## Revendications

1. Dispositif optoélectronique (1), comprenant
- un équipement optique (3) avec une structure optique (4) qui présente plusieurs éléments optiques (4a) et avec un concentrateur (5),
- une puce à semiconducteur (2) émettant du rayonnement ou recevant du rayonnement, avec une structure de contact (6) qui présente plusieurs éléments de contact (6a) en vue de la mise en contact électrique de la puce à semiconducteur (2) et qui est écartée verticalement de la structure optique (4), sachant que les éléments de contact (6a) sont disposés en cas de projection de la structure de contact (6) dans le plan de la structure optique (4) dans des interstices entre les éléments optiques (4a) et sachant que
- le concentrateur (5) présente sur un côté tourné vers la puce à semiconducteur (2) une plus petite aperture que sur le côté détourné de la puce à semiconducteur (2),
- la structure optique (4) est disposée sur le côté du concentrateur (5) tourné vers la puce à semiconducteur (2),
- le concentrateur (5) est un corps plein et **caractérisé en ce que**
- le concentrateur (5) et la structure optique (4) sont constitués en monobloc.

2. Dispositif optoélectronique (1) selon la revendication 1, sachant que la structure de contact (6) est appliquée sur une surface de passage du rayonnement (2a) de la puce à semiconducteur (2) tournée vers l'équipement optique (3).

3. Dispositif optoélectronique (1) selon une quelconque des revendications précédentes,
sachant que la structure optique (4) est une structure périodique et que les éléments optiques (4a) constituent par exemple un système de lentilles ou une grille optique.

4. Dispositif optoélectronique (1) selon une quelconque des revendications précédentes,
sachant que la structure optique (4) contient du verre.

5. Dispositif optoélectronique (1) selon les revendications 3 ou 4,
sachant que la structure de contact (6) est une structure périodique dont la périodicité concorde avec la périodicité de la structure optique (4).

6. Dispositif optoélectronique (1) selon la revendication 5, sachant que la structure de contact (6) présente des éléments de contact (6a) disposés en réseau, notamment des barrettes de contact.

7. Dispositif optoélectronique (1) selon une quelconque des revendications précédentes,
sachant que le concentrateur (5) est un concentrateur parabolique.

8. Dispositif optoélectronique (1) selon une quelconque des revendications précédentes,
sachant que la puce à semiconducteur (2) présente une zone émettant du rayonnement ou recevant du rayonnement, qui est fonctionnelle dans les zones couvertes par la structure de contact (6).

9. Dispositif optoélectronique (1) selon une quelconque des revendications précédentes,
sachant qu'un interstice (8) entre la structure optique (4) et la puce à semiconducteur (2) présente un indice de réfraction différent de la structure optique (4).

10. Dispositif optoélectronique (1) selon la revendication précédente,
sachant que dans l'interstice (8) se trouve de l'air ou de la silicone.

11. Dispositif optoélectronique (1) selon une quelconque des revendications précédentes,
sachant que la puce à semiconducteur (2) émettant du rayonnement est une diode luminescente.

12. Dispositif optoélectronique (1) selon une quelconque des revendications 1 à 10,
sachant que la puce à semiconducteur (2) recevant du rayonnement est un détecteur de rayonnement ou une cellule solaire.

13. Dispositif optoélectronique (1) selon une quelconque des revendications précédentes,
sachant qu'une surface de la plus petite aperture du concentrateur (5) est aussi grande qu'une surface sur plan de la structure optique (4).
